# EUROPEAN PATENT APPLICATION

(11) **EP 3 174 034 A1**
(43) Date of publication of application: **31.05.2017**
(21) Application number: 14901342.7
(22) Date of filing: 02.09.2014
(51) Int. Cl.: G09F 9/33

(54) **DISPLAY MODULE AND ELECTRONIC DEVICE HAVING SAID DISPLAY MODULE**

(71) Applicant: Shenzhen Royole Technologies Co. Ltd., Shenzhen, Guangdong 518052 (CN)
(72) Inventor: YANG, Songling, Shenzhen Guangdong 518052 (CN); LIU, Zihong, Shenzhen Guangdong 518052 (CN)
(74) Representative: Johnson, Richard Alan
(86) International application number: PCT/CN2014/000817
(87) International publication number: WO 2016/033703

(57) **Abstract**

A display module and an electronic device having the display module are provided. The display module (10) includes a substrate (20) and a flexible screen (30). The substrate (20) may include a front surface (22) having a first curvature, a back surface (24) opposite to the front surface (22), and a side surface (26) located beside the front surface (22) and having a second curvature, and the second curvature is larger than the first curvature. The flexible screen (30) may include a non-display region (38) and an effective region (36b) having a light-emitting element array (31), the effective region (36) may include a main portion (36a) bonded to the front surface (22) and an edge portion (36b) bonded to the side surface (26), and the non-display region (38) at least partly extends to the back surface (24). The non-display region (38) can extend to the back surface (24), therefore, the proportion that the effective region (36) takes up the display module increases.

## Description

### TECHNICAL FIELD

The present disclosure relates to display modules, and particularly to a display module having a greater viewable area proportion.

### BACKGROUND

For the structure of liquid crystal display (LCD) panels, liquid crystal is arranged between two parallel rigid rectangular glass substrates. Thin film transistors (TFTs) are arranged on the lower substrate glass, and color filters are arranged on the upper substrate glass. The rotation directions of the liquid crystal molecules are controlled by change of signal and voltage of the TFTs, so that whether polarized light of each pixel can emit is controlled and the display purpose is achieved. As the liquid crystal is liquid, the periphery of the upper and lower glass substrates is provided with a sealing device for example sealing adhesive to seal the liquid crystal, which results in that the periphery of the liquid crystal panel is provided with a frame which cannot display images.

With the development of technology, organic light-emitting diode (OLED) panels are developed, and the OLED panel includes two layers of electrode arranged on the rigid glass substrate and a layer of organic material sandwiched between the two layers of electrode. As the organic material cannot randomly flow, a frame is not needed to seal the organic material. A present OLED panel includes a rectangular effective display region arranged in the center of the OLED panel and a wiring region arranged in the periphery of the OLED panel, and the wiring region is used to couple control lines and data lines of the effective region to corresponding controllers. As the wiring region does not have display function, a proportion that the effective region of the OLED panel takes up the whole panel reduces, that is, the viewable area proportion is still smaller. Presently, with the development of flexible OLED screens, a greater development space for further improving the viewable area proportion exists.

### SUMMARY

The present disclosure provides a display module having a flexible screen and a greater viewable area proportion.

A display module may include a substrate and a flexible screen. The substrate may include a front surface having a first curvature, a back surface opposite to the front surface, and a side surface located beside the front surface and having a second curvature, and the second curvature is larger than the first curvature. The flexible screen may include a non-display region and an effective region having a light-emitting element array, the effective region may include a main portion bonded to the front surface and an edge portion bonded to the side surface, and the non-display region at least partly extends to the back surface.

The present disclosure further provides a display module. The display module may include a rigid transparent plate and a flexible screen. The rigid transparent plate may include a main body having a first curvature and a side surface located beside the main body and having a second curvature, and the second curvature is larger than the first curvature. The flexible screen may include a non-display region and an effective region having a light-emitting element array, the effective region may include a main portion bonded to the main body and an edge portion bonded to the side surface, and the non-display region at least partly overlaps the effective region.

The present disclosure further provides an electronic device having the above display module.

In the present disclosure, all of viewable edges of the display module can display images, without frame, thus, the viewable area proportion of the display module increases. When the display module is assembled in an electronic device for example a mobile phone, edges of two sides of the mobile phone can be designed to do not have a frame, thus the attraction of the mobile phone is improved.

### BRIEF DESCRIPTION OF THE DRAWINGS

The following accompanying drawings are used to specifically illustrate various embodiments of the present disclosure in combination with detailed embodiments. It can be understood that sizes and proportion relationships of various elements illustrated by the accompanying drawings do not represent actual sizes and actual proportion relationships, and the accompanying drawings are diagrammatic views for clear illustration, and should not be understood as limitations for the present disclosure.
FIG. 1 is a diagrammatic view of a display module in accordance with a first embodiment of the present disclosure.
FIG. 2 is a partially exploded view of the display module of FIG. 1, viewed from another viewpoint.
FIG. 3 is an expanded view of a flexible screen of the display module of FIG. 1 before assembled.
FIG. 4 is a partially diagrammatic view of a light-emitting element array of the flexible screen of FIG. 3.
FIG. 5 is a cross-section view of the display module of FIG. 1, taken along line V-V.
FIG. 6 is a diagrammatic view of a display module in accordance with a second embodiment of the present disclosure, viewed from a viewpoint similar to that of FIG. 2.
FIG. 7 is an expanded view of a flexible screen of the display module of FIG. 6 before assembled.
FIG. 8 is a cross-section view of a display module in accordance with a third embodiment of the present disclosure.
FIG. 9 is a cross-section view of a display module in accordance with a fourth embodiment of the present disclosure.
FIG. 10 is a cross-section view of a display module in accordance with a fifth embodiment of the present disclosure.
FIG. 11 is a cross-section view of a display module in accordance with a sixth embodiment of the present disclosure.
FIG. 12 is a cross-section view of an electronic device having the display module of one embodiment of the present disclosure.

### DETAILED DESCRIPTION

To make the purposes, technical solutions, and advantages of the present disclosure be clearer, the following will further specifically illustrate the present disclosure in combination with various embodiments and the accompanying drawings. It can be understood that the described embodiments are just used to illustrate the present disclosure, and not used to limit the present disclosure. Furthermore, illustrated proportion relationships do not represent actual proportion relationships, and are just for illustration.

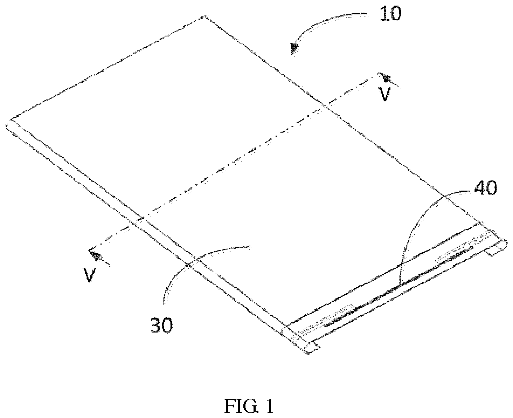

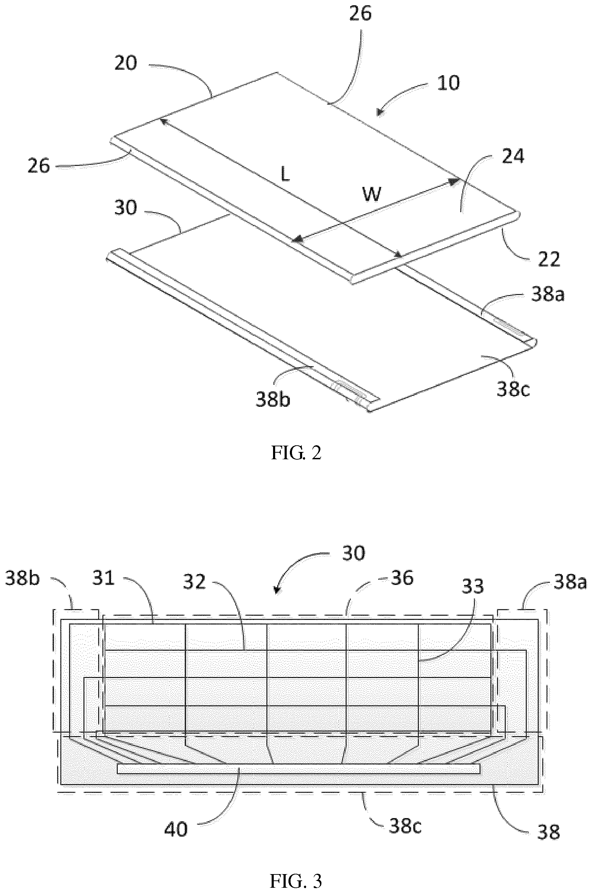

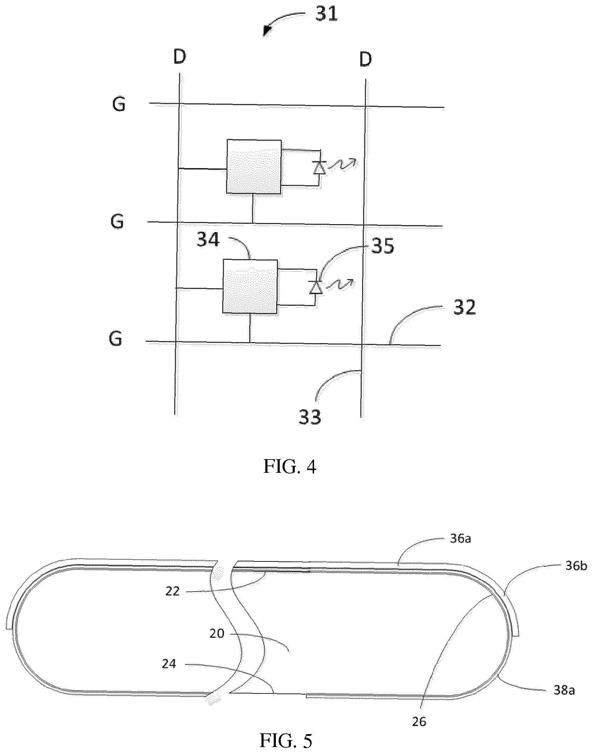

In combination with FIG. 1 and FIG. 2, FIG.1 and FIG. 2 are diagrammatic views of a display module 10 before assembled and after assembled in accordance with a first embodiment of the present disclosure. The display module 10 includes a substrate 20, a flexible screen 30, and an integrated controller 40. The substrate 20 is rectangular and includes a front surface 22, a back surface 24 opposite to the front surface 22, and two side surfaces 26 extending along a longitudinal direction of the substrate 20. The front surface 22 and the back surface 24 are planar faces parallel to each other. Each side surface 26 is a semi-cylindrical surface, and is tangent to the front surface 22 and the back surface 24, and the feature is more apparent in FIG. 5. The length of the substrate 20 is L, and the width (the maximum distance between the two side surfaces 26) is W.

In combination with FIG. 3 and FIG. 4, the flexible screen 30 is rectangular after expanded, and includes a rectangular effective region 36 having a light-emitting element array 31 and a non-display region 38. The length of the effective area 36 is L, and the width is larger than W. The light-emitting element array 31 includes gate lines 32 and data lines 33 which are mutually orthogonal, control circuits 34 each arranged between the adjacent gate line 32 and data line 33, and light emitting units 35 each coupled to one corresponding control circuit 34, for example, organic light emitting diodes. Each control circuit 34 is coupled to the corresponding gate line 28 and data line 26 to receive corresponding control instructions, so as to control on or off of the light emitting unit 35. The odd gate lines 32 and the even gate lines 32 respectively extend to two opposite ends of the non-display region 38 which are located in the effective region 36 and parallel to the longitudinal direction of the substrate 20 (the callouts are 38a and 38b), and further extend to a side of the non-display region 38 which is perpendicular to the longitudinal direction of the substrate 20 (the callout is 38c). The data lines 33 also extend from the effective region 36 to the non-display region 38c. The integrated controller 40 is arranged in the non-display region 38c, and coupled to the above gate lines 32 and data lines 33. The integrated controller 40 generates the above instructions. The length of the integrated controller 40 can be less than the length of the portion of the effective region 36 which is perpendicular to the longitudinal direction of the substrate 20, and at this point the above gate lines 32 and data lines 33 are set to converge to the center to be coupled to the integrated controller 40.

When assembling, the center of the effective region 36 is aligned with the center of the front surface 22 of the substrate 20, and the elongated sides of the effective region 36 and the front surface 22 of the substrate 20 are parallel to each other. The non-display regions 38a and 38b are then bent toward the back surface 24 along the side surfaces 26, and are secured to the back surface 24 via adhesive or other, so that the structure of FIG. 1 is formed. As illustrated by FIG. 5, the effective region 36 covers the front surface 22 of the substrate 20 and a half of the arc of each side surface 26. By doing so, the effective region 36 includes a main portion 36a bonded to the front surface 22 and edge portions 36b each bonded to one side surface 26. As illustrated by FIG, 2, at this point the non-display region 38c is located outside of the substrate 20. By doing so, when the display module 10 after assembled is viewed from the front, all of three edges of the display module 10 can display images, without frame, and only the non-display region 38c having the integrated controller 40 is viewable, thus the viewable area proportion of the display module 10 increases. When the display module 10 is assembled in a mobile phone, edges of two sides of the mobile phone can be designed to do not have a frame, thus the attraction of the mobile phone is improved. Certainly, the display module 10 can be applied in a tablet computer, an all-in-one computer, a display, a television, and other electronic devices. It can be understood that the display module 10 can be a quadrate or other shapes, and can be designed according to specific requirements of the electronic device. It can be understood that the length of the portion of a first side surface 26 covered by a first edge portion 36b, and the length of the portion of a second side surface 28 covered by a second edge portion 36c, is less than or larger than a half of the length of the arc of the first side surface 26 and the second side surface 28, which can be determined according to the specific design of the electronic device.

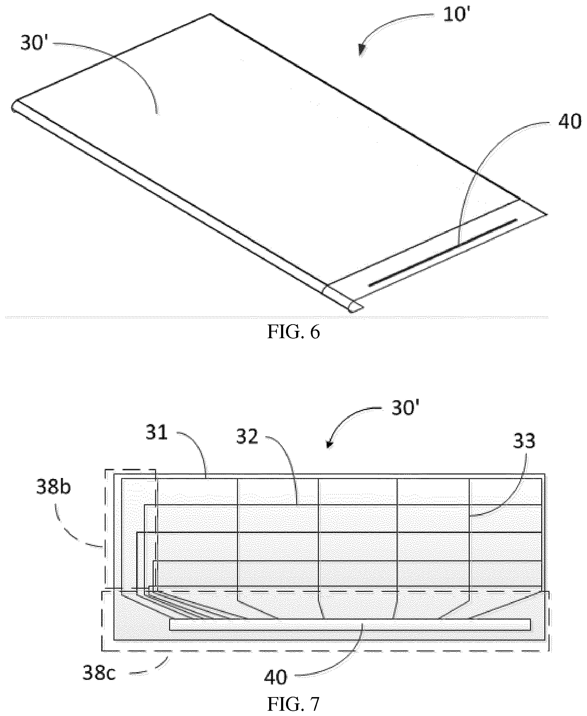

In combination with FIG. 6 and FIG. 7, a display module 10' in accordance with a second embodiment of the present disclosure is provided. A difference between the display module 10' and the display module 10 of the first embodiment is that all of the gate lines 32 of a flexible screen 30b' extend to the non-display region 38b which is parallel to the longitudinal direction of the substrate 20, and further extend to the non-display region 38c. The non-display region 38b extends to the back surface of the substrate, and the edge portion of the effective region opposite to the non-display region 38b is still bent and bonded to the side surface. In the embodiment, the effect that three edges can display images described in the first embodiment can also be realized.

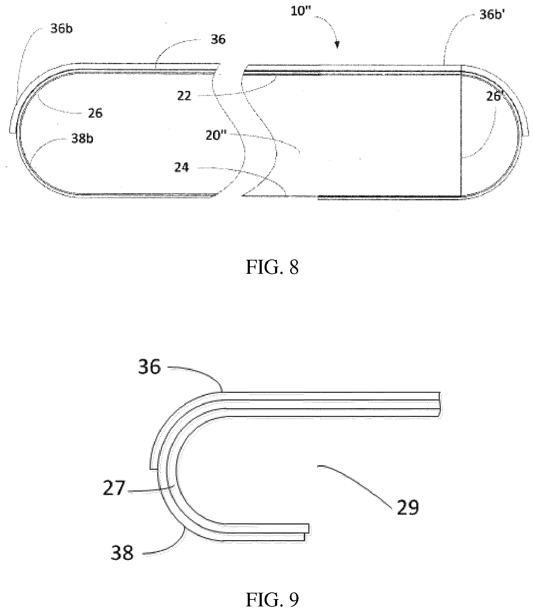

FIG. 8 is a display module 10" in accordance with a third embodiment of the present disclosure. A difference between the display module 10" and the display module 10' of the second embodiment is that just one side surface of the substrate 20 is a semi-cylindrical surface, and another side surface 26' is a flat surface. A side surface 36b' of the effective region 36 opposite to the non-display region 38b is aligned with the flat surface 26'. That is, the effective region 36 just includes one edge portion 36b bonded to side surface 26.

It can be understood that the non-display regions 38a and 38b can also include a gate driver arranged on an array substrate having a light-emitting element array, and the gate driver is manufactured by gate driver on array (GOA) technology.

Optionally, in combination with FIG. 9, the substrate of the first, the second, and the third embodiment can be formed when a rigid flat plate which can keep deformed shape after deformation is bent, for example, the substrate is formed when a thin steel plate 27 is bent. At this point, the steel plate can be deformed to form a half-surrounded structure, and a hollow cavity 29 can be used to receive other components, for example, a circuit board of an electronic device having the display module.

Optionally, the substrate of the first, second, and third embodiment of the present disclosure can be a battery. At this point, the battery can be designed to have a shape of the substrate illustrated by the corresponding embodiment. At this point, the thickness of the electronic device having the display module can be reduced.

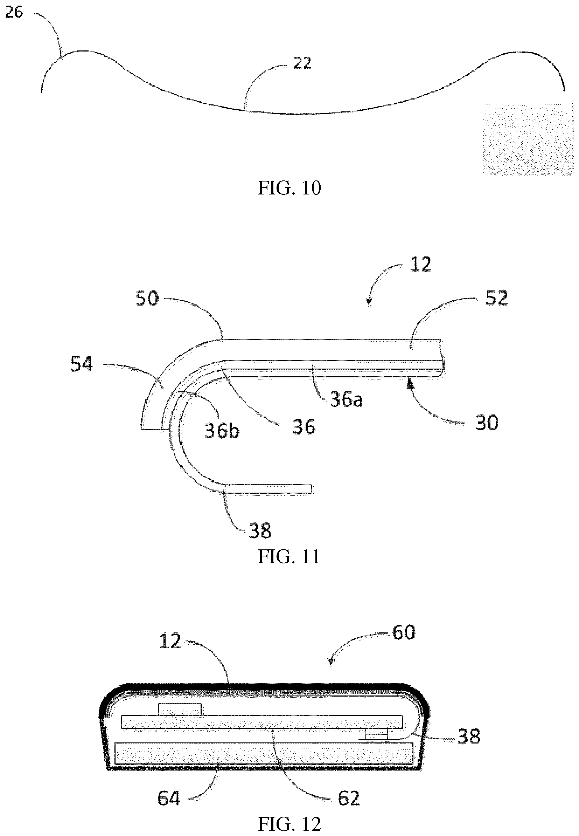

Optionally, the substrates illustrated by the above embodiments can be bent, and the front surface 22 having the flexible screen thereon can be recessed in a certain curvature, which is illustrated by FIG. 10. Certainly, the front surface 22 can also be upwardly convex in a certain curvature (not illustrated), or can be recessed or convex to form a substantial spherical surface. In brief, the front surface can be a concave surface or a convex surface, and the curvature of the concave surface or convex surface is less than that of the side surface. In addition, the side surface may not be a semi-cylindrical surface which is tangent to the front surface and the back surface, and what is needed is that the side surface can be smoothly connected to the front surface or the back surface, and the flexible screen will not be damaged by sharp angled objects. When the front surface is a flat surface, the curvature is zero, thus in combination with all of the above embodiments, all of that the curvature of the front surface of the substrate is less than that of the side surface of the substrate fall within the scope of the spirit of the present disclosure.

Preferably, in the various embodiments of the present disclosure, a touch layer (not illustrated) can be arranged on a surface of the flexible screen 30 opposite to the substrate 20, and the touch layer has a function of sensing touch.

In combination with FIG. 11, FIG. 11 is a cross-section view of a display module 12 in accordance with yet another embodiment of the present disclosure. A difference between the display module 12 of the present embodiment and the display module 10 of the first embodiment is that the display module 12 does not include the substrate 20, and instead includes a rigid transparent plate 50 which contacts the surface of the flexible screen 30 opposite to the substrate 20. The rigid transparent plate 50 can be rigid and transparent glass, ceramic, plastic, or other, and includes a rectangular flat main body 52 and two curved side edges 54 respectively connected to the elongated sides of the main body 52, and each side edge 54 can be bent to be a 1/4 arc. The effective area 36 of the flexible screen 30 can be secured to the rigid transparent plate 50 via adhesive or other, for example, optical clear adhesive (OCA), the main portion 36a of the effective region 36 is bonded to the main body 52, and the edge portion 36b is bonded to the side edge 54. A side surface of the rigid transparent plate 50 which is not bonded to the flexible screen 30 is a side facing a user. The non-display region can be secured when the display module 12 is assembled in an electronic device, and is coupled to corresponding circuits. Furthermore, at least one portion of the non-display region 38 overlaps the effective region 36. What needs to be pointed out is that the "overlap" does not mean direct overlapping of the non-display region 38 and the effective region 36, as illustrated by FIG. 11, the "overlap" indicates that at least a part of the projection of the non-display region 38 is in the effective region 36. When the rigid transparent plate 50 is an outmost glass plate of the electronic device, in relative to the above embodiments, the substrate can be omitted, which can further reduce the thickness of the electronic device.

When the display module is required to have touch function, a touch layer having a function of sensing touch can be arranged between the flexible screen 30 and the rigid transparent plate 50 to realize touch function. Specifically, the touch layer can be firstly bonded to the flexible screen 30 via OCA, and then the touch layer is bonded to the rigid transparent plate 50 via OCA.

It can be understood that for the transformations illustrated by the above embodiments which can be applied in the embodiment, in the embodiment the corresponding transformations can be realized. For example, the main body 52 is set to be curved, one edge portion 36 is included, and so on.

Specifically, in combination with FIG. 12, FIG. 12 is a diagrammatic view illustrating that the display module 12 is applied in an electronic device 60, for example a mobile phone. A circuit board 62 of the electronic device 60 can be arranged to be underneath the display module 12, and the circuit board 62 is at least partly surrounded by the display module 12. The non-display region of the display module 12 is bent towards the circuit board 62 to be coupled to the circuit board 62. The battery 64 is beneath the circuit board. The rigid transparent plate 50 of the display module 12 is a front panel of the electronic device for user operations.

The foregoing descriptions are merely preferred embodiments of the present disclosure, rather than limiting the present disclosure. Any modifications, equivalent substations, and improvements with the spirit and principle of the present disclosure shall fall within the protection scope of the present disclosure.

## Claims

**1.** A display module comprising:
a substrate comprising a front surface having a first curvature, a back surface opposite to the front surface, and a side surface located beside the front surface and having a second curvature, the second curvature being larger than the first curvature; and
a flexible screen comprising a non-display region and an effective region having a light-emitting element array, the effective region comprising a main portion bonded to the front surface and an edge portion bonded to the side surface, and the non-display region at least partly extending to the back surface.

**2.** The display module of claim 1, wherein the effective region only comprises one edge portion, the non-display region extending to the back surface extends to the back surface along the edge portion.

**3.** The display module of claim 2, wherein the substrate comprises the side surface and a second side surface opposite to the side surface, the second side surface is a flat surface, and one side of the front surface opposite to the edge portion is aligned with the second side surface.

**4.** The display module of claim 1, wherein the effective region comprises two edge portions located at two opposite sides of the main portion, and the non-display region extending to the back surface extends to the back surface at least along one of the edge portions.

**6.** The display module of any of claims 1-4, wherein the front surface is a flat surface, a concave surface, or a convex surface, and the side surface is smoothly connected to the front surface.

**7.** The display module of any of claims 1-4, wherein the front surface and the back surface are flat, and the side surface is an arc-shaped surface smoothly connected to the front surface and the back surface.

**8.** The display module of claim 1, wherein the substrate is formed when a rigid flat plate which keeps deformed shape after deformation is bent.

**9.** The display module of claim 1, wherein the substrate is a battery.

**10.** An electronic device comprising the display module of any of claims 1-9.

**11.** A display module comprising:
a rigid transparent plate comprising a main body having a first curvature and a side edge located beside the main body and having a second curvature, the second curvature being larger than the first curvature; and
a flexible screen comprising a non-display region and an effective region having a light-emitting element array, the effective region comprising a main portion bonded to the main body and an edge portion bonded to the side edge, and the non-display region at least partly overlapping the effective region.

**12.** The display module of claim 11, wherein the display module further comprises a touch layer sandwiched between the rigid transparent plate and the flexible screen, and the touch layer has a function of sensing touch.

**13.** The display module of claim 11, wherein the effective region comprises two edge portions located at two opposite sides of the main portion.

**14.** The display module of any of claims 11-13, wherein the main body is a flat plate, and the side edge is smoothly connected to the main body.

**15.** The display module of claim 14, wherein a projection of the non-display region along a direction perpendicular to the main body is on the edge portion and at least a part of the main body.

**16.** An electronic device comprising the display module of any of claims 11-15.

**17.** The electronic device of claim 16, wherein the rigid transparent plate is a glass panel for user direct contact.
